# EUROPÄISCHE PATENTSCHRIFT

(11) **EP 3 390 684 B1**
(45) Veröffentlichungstag und Bekanntmachung des Hinweises auf die Patenterteilung: **18.03.2020**
(21) Anmeldenummer: 16819815.8
(22) Anmeldetag: 07.12.2016
(51) Int. Cl.: C23C 14/34

(54) **BESCHICHTUNGSQUELLE MIT STRUKTURIERUNG**
STRUCTURED COATING SOURCE
SOURCE DE REVÊTEMENT STRUCTURÉE

(30) Priorität: 18.12.2015 AT 37115 U
(43) Veröffentlichungstag der Anmeldung: 24.10.2018
(73) Patentinhaber: PLANSEE COMPOSITE MATERIALS GMBH, DE-86983 Lechbruck am See (DE)
(72) Erfinder: POLCIK, Peter, D-86983 Lechbruck am See (AT); WÖRLE, Sabine, D-86983 Lechbruck am See (AT); INNERWINKLER, Ronnie, D-86983 Lechbruck am See (AT)
(74) Vertreter: Ciesla, Bettina
(86) Internationale Anmeldenummer: PCT/EP2016/002059
(87) Internationale Veröffentlichungsnummer: WO 2017/102069

(56) Entgegenhaltungen:
- WO-A1-2015/197196
- JP-A- H05 230 642
- JP-A- S62 278 261

## Beschreibung

Die Erfindung betrifft eine Beschichtungsquelle zur physikalischen Gasphasenabscheidung sowie ein Verfahren zur Herstellung einer Beschichtungsquelle zur physikalischen Gasphasenabscheidung.

Bei der physikalischen Gasphasenabscheidung (engl. Physical Vapor Deposition, PVD) wird über physikalische Verfahren Ausgangsmaterial in die Dampfphase übergeführt und anschließend auf einem zu beschichtenden Substrat abgeschieden.

Im Kontext der vorliegenden Offenbarung sind unter dem Begriff Beschichtungsquelle nicht nur, aber in besonderer Weise Beschichtungsquellen (oft auch gesamt als Target oder Sputtering Target bezeichnet), wie sie in einem PVD Sputterprozess (Kathodenzerstäubung) zur Abscheidung von Schichten auf ein dafür vorgesehenes Substratmaterial verwendet werden, zu verstehen.

Insbesondere Beschichtungsquellen die spröde Werkstoffe enthalten oder aus spröden Werkstoffen bestehen stellen eine große Herausforderung sowohl bei der Verwendung der Beschichtungsquelle während des Beschichtungsprozesses als auch bei der Herstellung der Beschichtungsquelle selbst dar.

So ist eine mechanische Bearbeitung solcher Beschichtungsquellen oder Komponenten davon bei deren Herstellung, die beispielsweise durch komplizierte Geometrien, die für den Einbau in verschiedene Beschichtungsanlagen erforderlich sein können, notwendig sein kann, oft nur schwer zu realisieren. Eine solche Bearbeitung ist oft nur über Schleifen und Drahterodieren möglich, eine zerspanende Bearbeitung hingegen nicht. Dies hat zur Folge, dass nur einfache Geometrien (Ronden, Platten, Ringe) fertigbar sind und hohe Kosten durch die Bearbeitung anfallen.

Besonders bei der Aufbringung hoher Leistungen bzw. hoher Leistungsdichten ist eine besonders gute Kühlung erforderlich, um thermisch induzierte Spannungen die zum Bruch der Beschichtungsquelle oder Komponenten davon, wie z.B. dem Beschichtungsmaterial, führen können zu vermeiden. Eine effiziente Kühlung solcher Beschichtungsquellen während des Beschichtungsprozesses wird üblicherweise durch Kühlwasser ermöglicht. Die Beschichtungsquellen werden dabei über Kühlplatten gekühlt die auf der Rückseite der Beschichtungsquellen angeordnet sind. Diese Kühlplatten werden wiederum durch das Kühlwasser, welches die während des Beschichtungsprozesses entstehende Wärme abführt, gekühlt.

Insbesondere bei flexiblen, elastischen Kühlplatten wird eine mechanische Belastung auf die Beschichtungsquelle ausgeübt, was wiederum zu einer plastischen Verformung der Beschichtungsquelle oder zum Bruch führen kann. Dieser Effekt wird zusätzlich dadurch verstärkt, dass sich die Stärke der Beschichtungsquelle, insbesondere des Beschichtungsmaterials während des Beschichtungsprozesses verringert. Dies hat zur Folge, dass es noch wahrscheinlicher zu Verformung und oder Bruch kommen kann.

Es ist daher üblich, vor allem Beschichtungsquellen die spröde Werkstoffe enthalten, konstruktiv mit Stützelementen, beispielsweise Rückplatten oder Stützrohren auszustatten.

Ein solches Stützelement kann auch zusätzlich als Wärmesenke dienen, d.h. durch das Aufbringen eines Stützelements mit einer im Vergleich zum Beschichtungsmaterial erhöhten Wärmeleitfähigkeit kann die im Beschichtungsprozess entstehende Wärme besser abgeführt werden. In einem solchen Fall wird die gesamte Anordnung aus Beschichtungsmaterial und Stützelement, das auch als Wärmesenke dienen kann, als Beschichtungsquelle bezeichnet.

Solche Stützelemente/Wärmesenken mit hoher Festigkeit und Steifigkeit können mittels unterschiedlicher Verfahren auf Beschichtungsmaterialien mit geringer Zähigkeit (sprödes Materialverhalten) aufgebracht werden. Im Fall eines signifikanten Unterschiedes der Wärmeausdehnungskoeffizienten von Stützelemente/Wärmesenke und Beschichtungsmaterial kann es während des Beschichtungsverfahrens zur Entstehung von Rissen im Beschichtungsmaterial bzw. zum Bruch des Beschichtungsmaterials kommen.

Die JP62278261 beschreibt ein Verfahren bei dem nach einem Fügeschritt über Indiumbonden gezielt Risse in ein sprödes Beschichtungsmaterial eingebracht werden, um einer Rissbildung während des Beschichtungsprozesses selbst vorzubeugen. Damit wird ein stabilerer Beschichtungsprozess gewährleistet.

Die PCT/EP2015/001298 beschreibt ein Verfahren bei dem nach einem Fügeschritt über Hartlöten ebenfalls gezielt Risse in ein sprödes Beschichtungsmaterial eingebracht werden um in weiterer Folge einen stabileren Sputterprozess zu ermöglichen. Hierbei entstehen die Risse beim Abkühlen von der Temperatur des Hartlötens oder die Rissbildung wird nachfolgend noch durch einen Strahlprozess unterstützt. Damit diese Rissbildung stattfindet muss der Ausdehnungskoeffizient des Stützelements/der Wärmesenke geringer als jener des Beschichtungsmaterials sein.

In beiden genannten Verfahren ist die Entstehung der Risse zufällig und es kann zu einem Abplatzen kleinerer Stücke des Beschichtungsmaterials kommen.

Aufgabe der vorliegenden Erfindung ist es, eine gegenüber dem Stand der Technik verbesserte Beschichtungsquelle sowie ein Verfahren zur Herstellung einer solchen Beschichtungsquelle zur physikalischen Gasphasenabscheidung anzugeben.

Gelöst werden diese Aufgaben durch eine Beschichtungsquelle mit den Merkmalen des Anspruchs 1 sowie ein Verfahren mit den Merkmalen von Anspruch 13. Vorteilhafte Ausführungsformen der Erfindung sind in den abhängigen Ansprüchen definiert.

Gemäß der Erfindung wird eine Beschichtungsquelle zur physikalischen Gasphasenabscheidung bereitgestellt, die ein Beschichtungsmaterial das aus einem spröden Werkstoff besteht und Risse aufweist. Weiters weist die Beschichtungsquelle ein Stützelement auf, das an einer Oberfläche des Beschichtungsmaterials mit diesem verbunden ist. Das Beschichtungsmaterial der erfindungsgemäßen Beschichtungsquelle weist weiter eine Strukturierung an zumindest Teilen einer Oberfläche des Beschichtungsmaterials auf.

Unter einem spröden Werkstoff sind erfindungsgemäß jene Werkstoffe zu verstehen die eine Bruchdehnung von kleiner oder gleich 1% aufweisen und somit nahe der Elastizitätsgrenze ohne oder mit nur geringer plastischer Verformung brechen. Diese Werkstoffe und damit auch die daraus hergestellten Sputtering Targets haben also nur ein geringes plastisches Verformungsvermögen. Weiters haben spröde Werkstoffe eine geringe Zähigkeit, sie zeigen also nur einen geringen Widerstand gegen Rissbildung und Rissausbreitung. Beispiele für solche spröden Werkstoffe sind keramische Werkstoffe, insbesondere Boride, Nitride, Karbide, Silizide, Oxide aber auch metallische spröde Werkstoffe wie Cr oder Si oder intermetallische Verbindungen wie Ti₃Al oder TiAl₃ sowie Mischungen aus diesen Werkstoffen.

Die Strukturierung einer erfindungsgemäßen Beschichtungsquelle besteht aus Vertiefungen, Rillen, Kerben oder Schlitzen, die auf verschiedenartige Weise in zumindest Teile einer Oberfläche des Beschichtungsmaterials eingebracht werden können.

Das Beschichtungsmaterial selbst kann ein- oder mehrteilig ausgebildet sein. Ist die Beschichtungsmaterial mehrteilig ausgebildet, kann die Strukturierung in alle oder auch nur in einige der Teile des Beschichtungsmaterials eingebracht sein.

Die Form, beziehungsweise der Querschnitt dieser Vertiefungen, Rillen, Kerben oder Schlitze kann ebenfalls unterschiedlich ausgebildet sein. So kann der Querschnitt beispielsweise die Form eines Halbkreises, eines Rechtecks, eines Quadrats, eines Dreiecks, oder eines Trapezes aufweisen.

Die Tiefe der Strukturierung, also ihre räumliche Ausdehnung in Richtung der Dicke der Beschichtungsquelle, beträgt bevorzugt zwischen 0,1 und 5 mm. Die Tiefe der Strukturierung kann in Einzelfällen auch größer sein, es muss aber gewährleistet sein, dass zumindest 1 mm in Tiefenrichtung an Beschichtungsmaterial übrig bleibt.

Die Breite der Strukturierung, also ihre räumliche Ausdehnung quer zur Richtung der Vertiefungen, Rillen, Kerben, Schlitze, etc., beträgt bevorzugt zwischen 0,1 und 2 mm, bevorzugt zwischen 0,1 und 1 mm.

In bevorzugter Weise verlaufen die Risse weitgehend entlang der Strukturierung, das bedeutet, dass die Risse in der Strukturierung oder in der Nähe zur Strukturierung weitgehend parallel dazu verlaufen. Unter weitgehend parallel wird ein Rissverlauf von bis zu maximal 20°, bevorzugt bis zu maximal 10° abweichend von der Richtung der Strukturierung verstanden. Die Risse weisen also in ihrer Ausbreitung einen klar erkennbaren Bezug zur Strukturierung, beziehungsweise zur Anordnung der Strukturierung, auf. Somit verlaufen die Risse mit einem überwiegenden Anteil der gesamten Risslänge in der Strukturierung oder größtenteils parallel oder mit einem geringen Neigungswinkel dazu. Die Risse treten also in einem Muster auf, das weitgehend der Strukturierung, beziehungsweise der Anordnung der Strukturierung, folgt.

Durch die Strukturierung verlaufen die Risse nicht zufällig sondern folgen bevorzugt in ihrer Ausbreitung der Strukturierung. Die Risse werden zumindest weitgehend kontrolliert ausgebildet und die Größe der einzelnen rissfreien Bereiche des Beschichtungsmaterials (Bruchstücke) ist zumindest weitgehend vordefiniert. Es kann daher nicht oder nur in geringem Maße zu einem Abplatzen kleinerer Stücke des Beschichtungsmaterials kommen. Damit kann bei der Verwendung der Beschichtungsquelle sichergestellt werden, dass weder die Beschichtungsanlage noch die abgeschiedene Schicht durch dieserart abplatzende Stücke verunreinigt oder beschädigt wird.

Bevorzugt verlaufen die Risse mit einem Anteil an der gesamten Risslänge von mehr als 50% entlang der Strukturierung. Damit ist eine noch höhere Prozesssicherheit bei der Verwendung einer erfindungsgemäßen Beschichtungsquelle gewährleistet.

Die Risse reichen bevorzugt in ihrer Tiefe (räumliche Ausdehnung in Richtung der Dicke der Beschichtungsquelle) vollständig durch das Beschichtungsmaterial hindurch. Es liegt also zwischen den einzelnen Bruchstücken des Beschichtungsmaterials bevorzugt eine vollständige Materialtrennung vor.

Die Strukturierung liegt bevorzugt an der dem Stützelement abgewandten Oberfläche des Beschichtungsmaterials vor. Bei der Herstellung der Beschichtungsquelle entsteht an der dem Stützelement abgewandten Oberfläche des Beschichtungsmaterials eine betragsmäßig höhere Zugspannung als an der dem Stützelement zugewandten Oberfläche (diese ist näher an der neutralen Faser der auf Biegung beanspruchten Beschichtungsquelle). Durch eine Strukturierung an der dem Stützelement abgewandten Oberfläche des Beschichtungsmaterials findet daher eine Rissbildung im spröden Beschichtungsmaterial zuverlässiger und reproduzierbarer statt.

Jedoch ist es auch möglich, dass die Strukturierung an der dem Stützelement zugewandten Oberfläche des Beschichtungsmaterials vorliegt. Eine solche Ausführungsform kann bei besonders spröden Beschichtungsmaterialien und bei speziellen Verhältnissen zwischen der Dicke des Beschichtungsmaterials d₂ und der Dicke des Stützelementes d₃ Vorteile bieten, da die entstehenden Risse in solchen Fällen besonders fein (geringer Abstand zwischen den Rissflanken) sind und die im Vergleich dazu grob (Breite der einzelnen Vertiefungen, Rillen, Kerben, etc.) eingebrachte Strukturierung nicht sichtbar ist.

Die Strukturierung kann in einer bevorzugten Ausführungsform aus einer Anordnung einer ersten Gruppe paralleler linienförmiger Vertiefungen und einer zweiten Gruppe paralleler linienförmiger Vertiefungen die in einem Winkel von 70° bis 110° zur ersten Gruppe paralleler linienförmiger Vertiefungen angeordnet sind bestehen. Eine solche Anordnung ist prozesstechnisch einfach zu realisieren und die Abstände der jeweiligen linienförmigen Vertiefungen zueinander können einfach an die Abmessungen der Beschichtungsquelle als auch an den Unterschied der thermischen Ausdehnungskoeffizienten des Beschichtungsmaterials und des Stützelementes und in weiterer Folge die resultierenden Spannungen angepasst werden. Weiters entstehen durch eine Anordnung in einem Winkel von 70° bis 110° der Gruppen der Vertiefungen zueinander keine zu spitzen Winkel und daher keine ungünstigen Spannungskonzentrationen.

In einer weiter bevorzugten Ausführungsform besteht die Strukturierung aus einer Anordnung einer ersten Gruppe paralleler linienförmiger Vertiefungen und einer zweiten Gruppe paralleler linienförmiger Vertiefungen die rechtwinkelig zur ersten Gruppe paralleler linienförmiger Vertiefungen angeordnet sind. Bei einer solchen Anordnung werden ungünstige Spannungskonzentrationen noch weiter vermieden.

Alternativ dazu kann die Strukturierung auch in anderen geometrischen Ausbildungen vorliegen, beispielsweise in Form von konzentrischen Kreisen, die optional mit einer sternförmigen Anordnung von Linien überlagert sein kann. Auch eine spiralförmige Anordnung anstatt der konzentrischen Kreise ist denkbar.

Der thermische Ausdehnungskoeffizient des Beschichtungsmaterials α₂ ist bevorzugt größer als der thermische Ausdehnungskoeffizient des Stützelements α₃. Durch ein solches Verhältnis der thermischen Ausdehnungskoeffizienten zueinander wird bei der Herstellung der Beschichtungsquelle, die üblicherweise zumindest einen Verfahrensschritt bei erhöhten Temperaturen beinhaltet, bevorzugt erreicht, dass sich das Beschichtungsmaterial beim Abkühlen von der erhöhten Temperatur stärker zusammenzieht als das Stützelement und eine Zugspannung in das Beschichtungsmaterial eingebracht wird, die wiederum zu einer besonders verlässlichen und reproduzierbaren Entstehung der Risse führt. Je größer der Unterschied der thermischen Ausdehnungskoeffizienten des Beschichtungsmaterials α₂ und des Stützelements α₃, desto höher ist auch der Betrag der eingebrachten Spannungen.

Eine erfindungsgemäße Beschichtungsquelle kann ein Beschichtungsmaterial aus unterschiedlichen spröden Werkstoffen aufweisen. So ist es möglich, dass das Beschichtungsmaterial aus Karbiden (z.B.: TiC, SiC, WC), Boriden (z.B.: TiB₂, VB₂, CrB₂), Nitriden (z.B.: TiN, AIN, TiNAIN), Siliziden (z.B.: TiSi₂, CrSi₂, MoSi₂), Oxiden (z.B.: Al₂O₃, (Al,Cr)₂O₃), spröden Metallen (z.B.: Cr, Si), intermetallischen Phasen (z.B.: Ti₃Al, TiAl₃, Al₄Cr) oder auch Mischungen aus den vorgenannten Werkstoffen besteht. Durch die Strukturierung ist es einfach möglich eine Beschichtungsquelle mit einem Beschichtungsmaterial aus einem spröden Werkstoff zu fertigen und die Beschichtungsquelle auch mit hohen Leitungsdichten zu betreiben.

Eine erfindungsgemäße Beschichtungsquelle weist bevorzugt ein Beschichtungsmaterial auf, das aus TiB₂, SiC, B₄C, MoSiB, oder CrSiB besteht. Es hat sich herausgestellt, dass in diesen Beschichtungsmaterialien besonders gut eine Strukturierung eingebracht werden kann und die Risse in besonders gleichmäßiger Art und Weise verlaufen.

Eine erfindungsgemäße Beschichtungsquelle weist weiter bevorzugt ein Stützelement aus Molybdän, Wolfram, Tantal, einer Molybdänbasislegierung, einer Wolframbasislegierung oder einer Tantalbasislegierung auf. Mit Molybdänbasislegierung, Wolframbasislegierung oder Tantalbasislegierung sind im vorliegenden Fall Legierungen oder Verbundwerkstoffe gemeint, die respektive mehr als 50 at% Molybdän, Wolfram oder Tantal enthalten. Molybdän, Wolfram, Tantal, Molybdänbasislegierungen, Wolframbasislegierungen oder Tantalbasislegierungen sind für die Verwendung in einem entsprechenden Stützelement besonders auch deswegen geeignet weil sie eine besonders vorteilhafte Eigenschaftskombination aus einer ausreichend hohen Wärmeleitfähigkeit, einem hohen E-Modul, also einer hohen Steifigkeit, und einem relativ geringen thermischen Ausdehnungskoeffizienten aufweisen.

In besonders bevorzugten Ausführungsformen ist der E-Modul des Stützelements E₃ größer oder gleich 300 GPa. Der E-Modul des Stützelements ist noch weiter bevorzugt kleiner 500 GPa.

Aus wirtschaftlichen Gründen wird angestrebt, dass das Verhältnis Verhältnis X = d₂/(d₂+d₃) so hoch wie technisch möglich ist, sprich die Dicke des Beschichtungsmaterials d₂ einen hohen Anteil an der Gesamtdicke der Beschichtungsquelle d₁ = d₂+d₃ hat.

Es hat sich aber überraschend herausgestellt, dass eine gezielte Einbringung von Rissen ohne Strukturierung wie im Stand der Technik beschrieben nur gut bei Beschichtungsquellen funktioniert, wo das Beschichtungsmaterial eine im Verhältnis zum Stützelement vergleichbare oder geringe Dicke aufweist. Bei Beschichtungsmaterialien, die zu dick im Vergleich zum Stützelement sind kommt es bei der Herstellung der Beschichtungsquelle zu einer Durchbiegung des Stützelements anstatt einer Rissbildung im Beschichtungsmaterial. Es wird vermutet, dass in solchen Fällen die Zugspannungen im Beschichtungsmaterial niedriger als die Bruchspannung des Beschichtungsmaterials sind. Solcherart verformte (durchgebogene) Beschichtungsquellen können zum einen nicht sachgemäß in eine Beschichtungsanlage eingebaut werden. Zum anderen würde eine solcherart verformte Beschichtungsquelle bedingt durch den während des Beschichtungsprozesses fortschreitenden Abtrag und die damit abnehmende Dicke des Beschichtungsmaterials plötzlich beim Erreichen der kritischen Spannung reißen und wiederum zu einer Störung des Beschichtungsprozesses führen.

Eine erfindungsgemäße Beschichtungsquelle weist bevorzugt ein Verhältnis X = d₂/(d₂+d₃) der Dicke des Beschichtungsmaterials d₂ zur Summe d₂+d₃ der Dicke des Beschichtungsmaterials d₂ und Dicke des Stützelements d₃ von größer 0,5 auf. Sinnvoll ist noch weiter bevorzugt ein maximales Verhältnis X von 0,9.

Eine erfindungsgemäße Beschichtungsquelle weist noch weiter bevorzugt ein Verhältnis X = d₂/(d₂+d₃) der Dicke des Beschichtungsmaterials d₂ zur Summe d₂+d₃ der Dicke des Beschichtungsmaterials d₂ und Dicke des Stützelements d₃ von größer oder gleich 0,6 auf. Sinnvoll ist noch weiter bevorzugt ein maximales Verhältnis X von 0,85.

Erfindungsgemäße Beschichtungsquellen können sowohl plattenförmig als auch rohrförmig sein, eine gezielte Risseinbringung entlang einer Strukturierung ist für beide Arten von Beschichtungsquellen möglich und hat den Vorteil, dass die Risse nicht zufällig verlaufen sondern in ihrer Ausbreitung bevorzugt der Strukturierung folgen. Daher kann es wie oben beschrieben nicht oder nur in geringem Maße zu einem Abplatzen kleinerer Stücke des Beschichtungsmaterials, und damit aus der Beschichtungsquelle, kommen.

In einer bevorzugten Ausführungsform ist die Beschichtungsquelle plattenförmig ausgebildet. Das Stützelement ist in so einem Fall als eine Rückplatte ausgebildet. Durch die sich in einer erfindungsgemäßen Beschichtungsquelle während deren Herstellung ausbildenden komplexen Spannungszustände ist die gezielte Einbringung von Rissen entlang einer Strukturierung in einer plattenförmigen Beschichtungsquelle sehr gut zu realisieren.

Alternativ bevorzugt ist eine Ausführungsform in der die Beschichtungsquelle rohrförmig ausgebildet ist. Das Stützelement ist in so einem Fall als Stütz- oder Trägerrohr ausgebildet ist. Auch im Fall einer rohrförmigen Beschichtungsquelle liegen ähnliche Kriterien und Voraussetzungen vor, die eine gezielte Ausbreitung von Rissen über das Einbringen einer Strukturierung begünstigen. Auch bei einer rohrförmigen Beschichtungsquelle ist es besonders vorteilhaft wenn der thermische Ausdehnungskoeffizient des Beschichtungsmaterials α₂ größer als der thermische Ausdehnungskoeffizient des Stützelements (Stütz- oder Trägerrohrs) α₃ ist.

Die vorliegende Erfindung stellt auch ein Verfahren zur Herstellung einer Beschichtungsquelle zur physikalischen Gasphasenabscheidung bereit. Ein solches Verfahren enthält die folgenden Schritte:
- Bereitstellen eines Beschichtungsmaterials (2) das aus einem Werkstoff mit einer Bruchdehnung von kleiner oder gleich 1% besteht;
- Strukturieren des Beschichtungsmaterials (2) zur Erzeugung einer Strukturierung (5) an zumindest Teilen einer Oberfläche des Beschichtungsmaterials (2), wobei die Strukturierung (5) aus Vertiefungen, Rillen, Kerben oder Schlitzen besteht, mit der Maßgabe, dass die Tiefe der Strukturierung (5) so groß ist, dass in Tiefenrichtung mindestens 1 mm an Beschichtungsmaterial (2) übrig bleibt.;
- Bereitstellen eines Stützelements (3);
- Verbinden des Beschichtungsmaterials (2) mit dem Stützelement (3);
- Einbringung von Rissen (4) in das Beschichtungsmaterial (2)

Durch ein erfindungsgemäßes Verfahren wird die Fertigung einer Beschichtungsquelle ermöglicht, die ein Beschichtungsmaterial aus einem spröden Werkstoff und ein Stützelement enthält, welche miteinander verbunden sind. Das Beschichtungsmaterial wird strukturiert und durch das erfindungsgemäße Verfahren werden Risse in das Beschichtungsmaterial eingebracht.

Beispiele für Werkstoffe die eine Bruchdehnung kleiner oder gleich 1% aufweisen sind keramische Werkstoffe, insbesondere Boride, Nitride, Karbide, Silizide, Oxide aber auch metallische spröde Werkstoffe wie Cr oder Si oder intermetallische Verbindungen wie Ti₃Al oder TiAl₃ sowie Mischungen aus diesen Werkstoffen.

Das Strukturieren des Beschichtungsmaterials zur Erzeugung einer Strukturierung kann durch verschiedene Verfahren erreicht werden. In einer bevorzugten Ausbildung des Verfahrens wird das Strukturieren des Beschichtungsmaterials durch Erodieren, Drahtschneiden Schleifen oder Trennschneiden verwirklicht. Dabei werden in zumindest Teile einer Oberfläche des Beschichtungsmaterials beispielsweise Vertiefungen, Rillen, Kerben oder Schlitze eingebracht, die unterschiedliche geometrische Anordnungen darstellen können.

Alternativ bevorzugt ist ein Strukturieren des Beschichtungsmaterials durch Einpressen eines profilierten Presswerkzeugs. Ein solches Einpressen einer Strukturierung durch ein profiliertes Presswerkzeug kann beispielsweise während einer pulvermetallurgischen Herstellung des Beschichtungsmaterials selbst stattfinden. Dabei kann das profilierte Presswerkzeug sowohl als Ober- als auch als Unterstempel in einer entsprechenden Pressvorrichtung ausgebildet sein. Es ist aber auch möglich, dass ein bereits vor- oder fertigverdichteter Rohling eines Beschichtungsmaterials separat über ein Einpressen eines profilierten Presswerkzeugs strukturiert wird. Weiters ist es auch möglich, dass nicht der Ober- oder Unterstempel selbst profiliert ist, sondern eine profilierte Zwischenplatte auf oder unter die Pulverschüttung oder den vor- oder fertigverdichteten Rohling gelegt wird.

Unabhängig davon auf welche Art und Weise das Strukturieren realisiert wird, können dadurch unterschiedliche geometrische Anordnungen einer Strukturierung verwirklicht werden. So kann das Strukturieren eine Anordnung einer ersten Gruppe paralleler linienförmiger Vertiefungen und einer zweiten Gruppe paralleler linienförmiger Vertiefungen die in einem Winkel von 70° bis 110° zur ersten Gruppe paralleler linienförmiger Vertiefungen angeordnet sind erzeugen. Eine solche Anordnung ist prozesstechnisch einfach zu realisieren und die Abstände der jeweiligen linienförmigen Vertiefungen zueinander können einfach an die Abmessungen der Beschichtungsquelle als auch an den Unterschied der thermischen Ausdehnungskoeffizienten des Beschichtungsmaterials und des Stützelementes und in weiterer Folge die resultierenden Spannungen angepasst werden. Eine solche Anordnung ist besonders vorteilhaft über Erodieren, Drahtschneiden, Schleifen oder Trennschneiden, aber auch über ein Einpressen eines profilierten Presswerkzeugs zu erzeugen.

Weiter bevorzugt kann das Strukturieren eine Anordnung einer ersten Gruppe paralleler linienförmiger Vertiefungen und einer zweiten Gruppe paralleler linienförmiger Vertiefungen die rechtwinkelig zur ersten Gruppe paralleler linienförmiger Vertiefungen angeordnet sind erzeugen. Bei einer solchen Anordnung werden ungünstige Spannungskonzentrationen noch weiter vermieden.

Alternativ dazu kann das Strukturieren auch andere geometrische Anordnungen erzeugen, beispielsweise eine Form von konzentrischen Kreisen, die optional mit einer sternförmigen Anordnung von Linien überlagert sein kann. Auch eine spiralförmige Anordnung anstatt der konzentrischen Kreise ist denkbar. Eine solche Anordnung ist besonders vorteilhaft über ein Einpressen eines profilierten Presswerkzeugs zu erzeugen.

Einer besonders vorteilhaften Ausgestaltung des erfindungsgemäßen Verfahrens wird das Strukturieren des Beschichtungsmaterials zur Erzeugung einer Strukturierung an zumindest Teilen der Oberfläche des Beschichtungsmaterials eingebracht, die sich nach dem Verbinden mit dem Stützelement auf der dem Stützelement abgewandten Oberfläche des Beschichtungsmaterials befindet.

In Anwendung des Verfahrens zur Herstellung einer Beschichtungsquelle entsteht an der dem Stützelement abgewandten Oberfläche des Beschichtungsmaterials eine betragsmäßig höhere Zugspannung als an der dem Stützelement zugewandten Oberfläche (diese ist näher an der neutralen Faser). Durch ein Strukturieren an der dem Stützelement abgewandten Oberfläche des Beschichtungsmaterials findet daher eine Rissbildung im spröden Beschichtungsmaterial zuverlässiger und reproduzierbarer statt.

Jedoch ist es auch möglich, dass das Strukturieren an der dem Stützelement zugewandten Oberfläche des Beschichtungsmaterials vorzunehmen. Ein solcher Verfahrensschritt kann bei besonders spröden Beschichtungsmaterialien und bei speziellen Verhältnissen zwischen der Dicke des Beschichtungsmaterials d₂ und der Dicke des Stützelementes d₃ Vorteile bieten, da die entstehenden Risse in solchen Fällen besonders fein (geringer Abstand zwischen den Rissflanken) sind und die im Vergleich dazu grob (Breite der einzelnen Vertiefungen, Rillen, Kerben, etc.) eingebrachte Strukturierung nicht sichtbar ist.

Ein Verbinden des Beschichtungsmaterials mit dem Stützelement kann ebenfalls auf unterschiedliche Art und Weise realisiert werden. Bevorzugt findet ein Verbinden des Beschichtungsmaterials mit dem Stützelement bei Temperaturen von mehr als 100°C und weniger als 1000°C statt.

In einer weiter bevorzugten Ausgestaltung des Verfahrens wird das Verbinden des Beschichtungsmaterials mit dem Stützelement durch Hartlöten bei Temperaturen zwischen 400°C bis 950°C realisiert. Durch ein Hartlöten in diesem Temperaturbereich kann eine ausgezeichnete thermische Stabilität der Beschichtungsquelle erreicht werden, die es erlaubt die Beschichtungsquelle im Beschichtungsprozess mit besonders hohen Leistungsdichten und somit hohen Abscheideraten zu betreiben. Während eines Beschichtungsprozesses wird normalerweise die Beschichtungskammer auf Temperaturen in der Größenordnung von 400°C geheizt. Die Beschichtungsquelle ist aber nicht gänzlich diesen Temperaturen ausgesetzt, da es zusätzlich von der Rückseite gekühlt wird. Durch ein Verbinden bei Temperaturen zwischen 400°C bis 950°C kann dafür gesorgt werden, dass die Beschichtungsquelle ähnliche thermische Belastungen, wie sie während des Beschichtungsprozesses auftreten, bereits durchlaufen hat und somit keine daraus resultierende Schädigung mehr erfahren kann. Eine Verbindung bei Temperaturen zwischen 400°C bis 950°C hat weiter zur Folge, dass der Unterschied der thermischen Ausdehnungskoeffizienten des Beschichtungsmaterials und des Stützelements in entsprechend hohen Spannungen, bevorzugt Zugspannungen, resultiert, welche wiederum die die Ausbildung der Risse begünstigen.

Besonders bevorzugt ist es, wenn die Einbringung der Risse durch ein Abkühlen von einer erhöhten Temperatur stattfindet. Unter erhöhte Temperatur werden im vorliegenden Fall Temperaturen von mehr als 100°C und weniger als 1000°C verstanden, die bevorzugt während des Verbindens des Beschichtungsmaterials mit dem Stützelement realisiert werden. Es ist aber auch möglich, dass nach dem Verbinden ein weiteres Aufheizen auf eine erhöhte Temperatur erfolgt, und die Einbringung der Risse dann beim Abkühlen von dieser erhöhten Temperatur erfolgt.

Noch weiter bevorzugt ist es, wenn die Einbringung der Risse durch ein Abkühlen von der Temperatur des Hartlötens stattfindet. Beim Abkühlen von der Temperatur des Hartlötens entsteht ein besonders vorteilhafter Temperaturgradient der eine lokale Erhöhung der Spannungen, im bevorzugten Fall Zugspannungen, im Beschichtungsmaterial hervorruft. Dadurch kommt es auch zusätzlich durch die Kerbwirkung der Strukturierung zu Rissbildung und Rissausbreitung entlang der Strukturierung und somit zu einem gezielt eingebrachten zu einem großen Anteil vordefinierten Rissnetzwerk im Beschichtungsmaterial, das bevorzugt weitgehend entlang der Strukturierung verläuft.

Alternativ zu einer Verbindung des Beschichtungsmaterials mit dem Stützelement mittels Hartlöten ist es auch möglich ein solches Verbinden über Kleben und eine Aushärtung des Klebers bei hohen Temperaturen zu verwirklichen. Eine Aushärtung dafür geeigneter Kleber erfolgt normalerweise bei etwa 120 bis 250°C. Die bei einem solchen Verfahrensschritt eingebrachten Temperaturgradienten sind im Vergleich zu einem Hartlötschritt also vergleichsweise klein. Eine Verbindung über Kleben ist besonders für Beschichtungsquellen mit sehr spröden Beschichtungsmaterialien und im Vergleich zum Werkstoff des Stützelementes sehr hohen thermischen Ausdehnungskoeffizienten geeignet.

Zusätzlich zu den bereits erwähnten Schritten kann ein erfindungsgemäßes Verfahren zusätzlich bevorzugt noch folgenden Schritt enthalten
- Strahlen der Beschichtungsquelle

Ein Strahlen der Beschichtungsquelle wird bevorzugt nach dem Verbinden an der dem Stützelement abgewandten Oberfläche des Beschichtungsmaterials vorgenommen. Als Strahlgut können abrasive oder nicht abrasive Medien eingesetzt werden. Durch ein Strahlen der Beschichtungsquelle kann die Ausbildung der Risse unterstützt werden, wobei dies durch den Aufprall des Strahlgutes (z.B. Sandstrahlen mit Korund), der wiederum die Spannungen im Beschichtungsmaterial weiter erhöht verursacht wird. Gleichzeitig kann es durch die Unterstützung der Rissbildung und Rissausbreitung im Beschichtungsmaterial zu einem Abbau der im Stützelement bei der Herstellung der Beschichtungsquelle entstandenen elastischen Dehnungen kommen.

Alternativ oder zusätzlich zu einer Strahlbehandlung kann eine thermische Behandlung der Beschichtungsquelle erfolgen, beispielsweise über eine schnelle Abkühlung mittels flüssigen Stickstoffs. Dadurch können lokal noch höhere Temperaturgradienten im Beschichtungsmaterial erzeugt werden, was wiederum die entstehenden Spannungen erhöht und die Ausbildung der Risse weiter unterstützt.

Ein erfindungsgemäßes Verfahren zur Herstellung einer Beschichtungsquelle eignet sich in besonderem Maße zur Herstellung einer erfindungsgemäßen Beschichtungsquelle wie oben beschrieben.

Ein erfindungsgemäßes Verfahren hat sich besonders vorteilhaft für die Herstellung von Beschichtungsquellen herausgestellt, bei denen die Dicke des Beschichtungsmaterials eine im Vergleich zum Stützelement hohe Dicke aufweist. Im Stand der Technik kommt es bei Beschichtungsmaterialien, die zu dick im Vergleich zum Stützelement sind, bei der Herstellung der Beschichtungsquelle zu einer Durchbiegung des Stützelements anstatt einer Rissbildung im Beschichtungsmaterial. Es wird vermutet, dass in solchen Fällen die Zugspannungen im Beschichtungsmaterial niedriger als die Bruchspannung des Beschichtungsmaterials sind. Solcherart verformte (durchgebogene) Beschichtungsquellen können zum einen nicht sachgemäß in eine Beschichtungsanlage eingebaut werden. Zum anderen würde eine solcherart verformte Beschichtungsquelle bedingt durch den während des Beschichtungsprozesses fortschreitenden Abtrags und der damit abnehmende dicke des Beschichtungsmaterials plötzlich beim Erreichen der kritischen Spannung reißen und wiederum zu einer Störung des Beschichtungsprozesses führen.

Aus wirtschaftlichen Gründen wird angestrebt, dass das Verhältnis Verhältnis X = d₂/(d₂+d₃) so hoch wie technisch möglich ist, sprich die Dicke des Beschichtungsmaterials d₂ einen hohen Anteil an der Gesamtdicke der Beschichtungsquelle d₁ = d₂+d₃ hat.

Besonders vorteilhaft hat sich ein erfindungsgemäßes Verfahren für die Herstellung einer Beschichtungsquelle herausgestellt die ein Verhältnis X = d₂/(d₂+d₃) der Dicke des Beschichtungsmaterials d₂ zur Summe d₂+d₃ der Dicke des Beschichtungsmaterials d₂ und Dicke des Stützelements d₃ von größer 0,5 auf. Sinnvoll ist noch weiter bevorzugt ein maximales Verhältnis X von 0,9.

Noch vorteilhafter hat sich ein erfindungsgemäßes Verfahren für die Herstellung einer Beschichtungsquelle herausgestellt die ein Verhältnis X = d₂/(d₂+d₃) der Dicke des Beschichtungsmaterials d₂ zur Summe d₂+d₃ der Dicke des Beschichtungsmaterials d₂ und Dicke des Stützelements d₃ von größer oder gleich 0,6 auf. Sinnvoll ist noch weiter bevorzugt ein maximales Verhältnis X von 0,85.

Anhand der folgenden Beispiele und Figuren werden Vorteile und Einzelheiten sowie besonders vorteilhafte Ausbildungen der Erfindung genauer erläutert.

### Beispiel 1 (nicht erfindungsgemäß):

Eine Beschichtungsquelle mit einem TiB₂ Beschichtungsmaterial das über Hartlöten mit einer Rückplatte aus dem Werkstoff MoCu70/30wt% verbunden wurde, wurde hergestellt. Der Durchmesser der Beschichtungsquelle war 150 mm und die Gesamtdicke d₁ war 12 mm. Das Beschichtungsmaterial wies eine Dicke d₂ von 6mm, die Rückplatte ebenfalls eine Dicke d₃ von 6mm auf. Das Verhältnis X = d₂/(d₂+d₃) war also 0,5. In diesem Fall ist der thermische Ausdehnungskoeffizient der MoCu70/30wt% Rückplatte mit 9,5 ppm/K (im Vergleich dazu 5,2 ppm/K für reines Mo) größer als derjenige des Beschichtungsmaterials von 7,3 ppm/K. Hier entstehen beim Abkühlen von der Temperatur des Hartlötens Druckspannungen im Beschichtungsmaterials, so dass es zur keiner Rissbildung senkrecht zur Oberfläche des Beschichtungsmaterials kommt und das Beschichtungsmaterial sich in Richtung der Rückplatte wölbt. Die Druckspannungen im Beschichtungsmaterial sind dabei so hoch, dass es über eine Ausbildung von Scherspannungen zu einem Abplatzen von Bruchstücken parallel zur Oberfläche der Beschichtungsquelle, beziehungsweise des Beschichtungsmaterial kommt.

### Beispiel 2 (nicht erfindungsgemäß)

Eine Beschichtungsquelle mit einem TiB₂ Beschichtungsmaterial das über Hartlöten mit einer dünneren Rückplatte aus Mo verbunden wurde, wurde hergestellt. Der Durchmesser der Beschichtungsquelle war 150 mm und die Gesamtdicke d₁ war 16 mm. Das Beschichtungsmaterial wies eine Dicke d₂ von 10mm, die Rückplatte eine Dicke d₃ von 6mm auf. Das Verhältnis X = d₂/(d₂+d₃) war also 0,625. In diesem Beispiel waren die durch das Abkühlen von der Temperatur des Hartlötens entstandenen Zugspannungen anscheinend zu gering, so dass es nicht zur Ausbildung von Rissen im Beschichtungsmaterial kam. Stattdessen entstand eine Wölbung des Beschichtungsmaterials in Richtung der Rückplatte.

### Beispiel 3 (nicht erfindungsgemäß)

Eine Beschichtungsquelle mit einem CrSiB Beschichtungsmaterial das über Hartlöten mit einer Rückplatte aus Mo verbunden wurde, wurde hergestellt.

Der Durchmesser der Beschichtungsquelle war 150 mm und die

Gesamtdicke d₁ war 12 mm. Das Beschichtungsmaterial wies eine Dicke d₂ von 6 mm, die Rückplatte eine Dicke d₃ von 6 mm auf.

Das Verhältnis X = d₂/(d₂+d₃) war also 0,5. Bei dem CrSiB Beschichtungsmaterial handelt es sich um die spröde Zusammensetzung CrSiB 92/3/5 at%. Durch das Abkühlen von der Temperatur des Hartlötens sind Risse senkrecht zur Oberfläche des Beschichtungsmaterials entstanden.

### Beispiel 4 (nicht erfindungsgemäß)

Eine Beschichtungsquelle mit einem CrSiB Beschichtungsmaterial das über Hartlöten mit einer dünneren Rückplatte aus Mo verbunden wurde, wurde hergestellt. Der Durchmesser der Beschichtungsquelle war 100 mm und die Gesamtdicke d₁ war 16 mm. Das Beschichtungsmaterial wies eine Dicke d₂ von 12 mm, die Rückplatte eine Dicke d₃ von 4 mm auf.

Das Verhältnis X = d₂/(d₂+d₃) war also 0,75. Bei dem CrSiB Beschichtungsmaterial handelt es sich um die spröde Zusammensetzung CrSiB 92/3/5 at%. Durch das Abkühlen von der Temperatur des Hartlötens sind keine Risse entstanden.

### Beispiel 5 (erfindungsgemäß)

Eine Beschichtungsquelle mit einem MoSiB Beschichtungsmaterial das über Hartlöten mit einer Rückplatte aus Mo verbunden wurde, wurde hergestellt. Der Durchmesser der Beschichtungsquelle war 150 mm und die Gesamtdicke d₁ war 12 mm. Das Beschichtungsmaterial wies eine Dicke d₂ von 6 mm, die Rückplatte eine Dicke d₃ von 6 mm auf. Das Verhältnis X = d₂/(d₂+d₃) war also 0,5. Bei dem MoSiB Beschichtungsmaterial handelt es sich um die spröde Zusammensetzung MoSiB 50/30/20 at%. Das Beschichtungsmaterial wurde vor dem Hartlöten mittels Drahtschneiden mit einer Strukturierung versehen. Durch das Abkühlen von der Temperatur des Hartlötens sind Risse senkrecht zur Oberfläche des Beschichtungsmaterials entstanden. Zusätzlich zu Rissen entlang der Strukturierung sind auch Risse vorhanden, die ein unregelmäßiges Netzwerk bilden. Es erfolgte kein Abplatzen kleinerer Stücke des Beschichtungsmaterials.

### Beispiel 6 (nicht erfindungsgemäß)

Eine Beschichtungsquelle mit einem TiB₂ Beschichtungsmaterial das über Hartlöten mit einer Rückplatte aus Mo verbunden wurde, wurde hergestellt. Der Durchmesser der Beschichtungsquelle war 150 mm und die Gesamtdicke d₁ war 12 mm. Das Beschichtungsmaterial wies eine Dicke d₂ von 6 mm, die Rückplatte eine Dicke d₃ von 6 mm auf. Das Verhältnis X = d₂/(d₂+d₃) war also 0,5. Das Beschichtungsmaterial wurde vor dem Hartlöten mittels Drahtschneiden mit einer Strukturierung versehen. Durch das Abkühlen von der Temperatur des Hartlötens sind Risse senkrecht zur Oberfläche des Beschichtungsmaterials entstanden. Diese Risse verlaufen weitestgehend entlang der Strukturierung. Es erfolgte kein Abplatzen kleinerer Stücke des Beschichtungsmaterials.

### Beispiel 7 (erfindungsgemäß)

Eine Beschichtungsquelle mit einem TiB₂ Beschichtungsmaterial das über Hartlöten mit einer Rückplatte aus Mo verbunden wurde, wurde hergestellt. Der Durchmesser der Beschichtungsquelle war 150 mm und die Gesamtdicke d₁ war 12 mm. Das Beschichtungsmaterial wies eine Dicke d₂ von 8 mm, die Rückplatte eine Dicke d₃ von 4 mm auf. Das Verhältnis X = d₂/(d₂+d₃) war also 0,67. Das Beschichtungsmaterial wurde vor dem Hartlöten mittels Drahtschneiden mit einer Strukturierung versehen. Diese war über Drahtschneiden mit zueinander rechtwinkelig angeordneten und 1 mm tiefen Schnitten vorgenommen worden. Durch das Abkühlen von der Temperatur des Hartlötens sind Risse senkrecht zur Oberfläche des Beschichtungsmaterials entstanden. Diese Risse verlaufen weitgehend entlang der Strukturierung. Es erfolgte kein Abplatzen kleinerer Stücke des Beschichtungsmaterials.

### Beispiel 8 (erfindungsgemäß)

Eine Beschichtungsquelle mit einem TiB₂ Beschichtungsmaterial das in Form von zylindrischen Ringen über Hartlöten mit einem rohrförmigen Stützelement (Stütz- bzw. Trägerrohr) aus Mo verbunden wurde, wurde hergestellt.

Der Durchmesser der insgesamt 5 TiB₂ Ringe betrug 116 mm außen und 91,5 mm innen, die Höhe (Ausdehnung in Richtung der Rotationsachse) der einzelnen Ringe betrug 30 mm. Der Durchmesser des Mo Stützrohres betrug 91,45 mm außen und 76,1 mm innen. Die Länge des Mo Stützrohres betrug insgesamt 200 mm. Das Beschichtungsmaterial hatte somit eine Dicke von 12,25 mm und das Stützrohr eine Dicke von 7,67 mm. Das Verhältnis X = d₂/(d₂+d₃) war also 0,62. Das Beschichtungsmaterial wurde vor dem Hartlöten mittels Drahtschneiden mit einer Strukturierung versehen. Diese war über Drahtschneiden mit zueinander parallel angeordneten und 1 mm tiefen Schnitten vorgenommen worden. Durch das Abkühlen von der Temperatur des Hartlötens sind Risse senkrecht zur Oberfläche des Beschichtungsmaterials entstanden. Diese Risse verlaufen weitgehend entlang der Strukturierung. Es erfolgte kein Abplatzen kleinerer Stücke des Beschichtungsmaterials.

Zusätzlich zu den Beispielen wurden einfache Berechnungen durchgeführt. Diese hatten das Ziel abzuschätzen, ab welchem Verhältnis X = d₂/(d₂+d₃) der Dicke des Beschichtungsmaterials d₂ zur Summe d₂+d₃ der Dicke des Beschichtungsmaterials d₂ und Dicke des Stützelements d₃ eine Strukturierung des Beschichtungsmaterials besonders vorteilhaft ist, um gemäß der Erfindung Risse zu generieren.

Es wird vermutet, dass eine Voraussetzung für die Ausbildung von Rissen im Beschichtungsmaterial ist, dass das Produkt der Zugfestigkeit des spröden Beschichtungsmaterials und seiner Dicke d₂ geringer ist als das Produkt der Streckgrenze und der Dicke d₃ der Rückplatte. Für diesen Grenzfall gilt ein Gleichsetzen der beiden Produkte. Betrachtet man das Beispiel von TiB₂ auf Mo mit der Zugfestigkeit von etwa 500 MPa für TiB₂ und der Streckgrenze von etwa 750 MPa für Mo, so ergibt sich in erster grober Näherung, dass bei einem Anteil der Dicke des Beschichtungsmaterials von 60% an der Gesamtdicke d₁ der Beschichtungsquelle die Grenzbedingung herrscht. Bei dünneren Beschichtungsmaterialien kann auch ohne Strukturierung ein Rissnetzwerk entstehen und bei dickeren Beschichtungsmaterialien wird die Rückplatte elastisch und/oder plastisch verformt bzw. biegt oder wölbt sich diese. Deshalb wurde in der CrSiB/Mo Beschichtungsquelle mit 6 mm CrSiB auf 6 mm Mo aus Beispiel 3 ein Rissnetzwerk ausgebildet, während die TiB₂/Mo Beschichtungsquelle mit 10 mm TiB₂ auf 6 mm Mo aus Beispiel 2 keine Risse im TiB₂ zeigte und die Mo Platte verbogen wurde. Mit einer Strukturierung wie beispielsweise in Beispiel 7 können Risse entlang der Strukturierung eingebracht werden, was vermutlich auf eine Verringerung des tragenden Querschnitts (der Dicke) des Beschichtungsmaterials oder auf eine Kerbwirkung und lokale Spannungserhöhung, bzw. eine Kombination daraus zurückzuführen ist.

Von den Figuren zeigen:
Fig. 1: Beschichtungsquelle (1), aufweisend ein Beschichtungsmaterial (2), ein Stützelement (3) und eine Strukturierung (5) vor der Einbringung der Risse.
Fig. 2: Draufsicht auf die Beschichtungsquelle von Fig. 1.
Fig. 3: Draufsicht auf eine erfindungsgemäße Beschichtungsquelle (1) nach der Einbringung der Risse (4).
Fig. 4: Beschichtungsquelle mit MoSiB Beschichtungsmaterial (Beispiel 5) nach dem Hartlöten und Reinigen mit ausgebildeten Rissen.
Fig. 5: Beschichtungsquelle mit TiB₂ Beschichtungsmaterial (Beispiel 6) hartgelötet auf Mo Rückplatte. Risse sichtbar gemacht durch Farbeindringprüfung mit fluoreszierender Farbe.
Fig. 6 Rohrförmige Beschichtungsquelle (1), mit Beschichtungsmaterial (2), Stütz- bzw. Trägerrohr (Stützelement) (3) und Strukturierung (5) nach der Einbringung der Risse (4) in a) Seitenansicht, in b) Draufsicht.

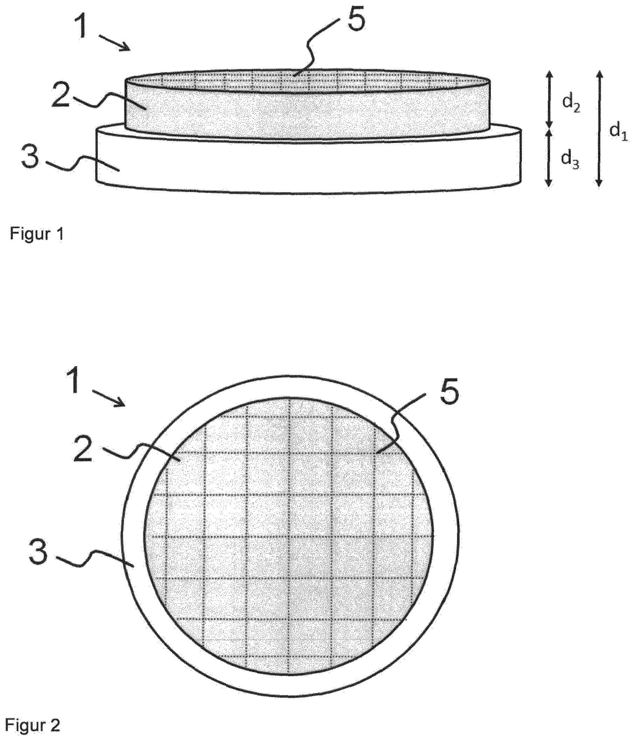

Figur 1 zeigt einen Beschichtungsquelle (1) zur physikalischen Gasphasenabscheidung vor der Einbringung der Risse. Die Beschichtungsquelle (1) weist ein Beschichtungsmaterial (2) und ein Stützelement (3) auf. Das Beschichtungsmaterial (2) ist mit dem Stützelement (3) an einer Oberfläche des Beschichtungsmaterials (2) verbunden. Das Beschichtungsmaterial (2) weist eine Strukturierung (5) auf. Die Strukturierung (5) besteht aus einer Anordnung einer ersten Gruppe paralleler linienförmiger Vertiefungen (strichliert dargestellt) und einer zweiten Gruppe paralleler linienförmiger Vertiefungen (strichliert dargestellt) die rechtwinkelig zur ersten Gruppe paralleler linienförmiger Vertiefungen angeordnet sind.

Figur 2 zeigt eine Draufsicht auf die Beschichtungsquelle von Figur 1.

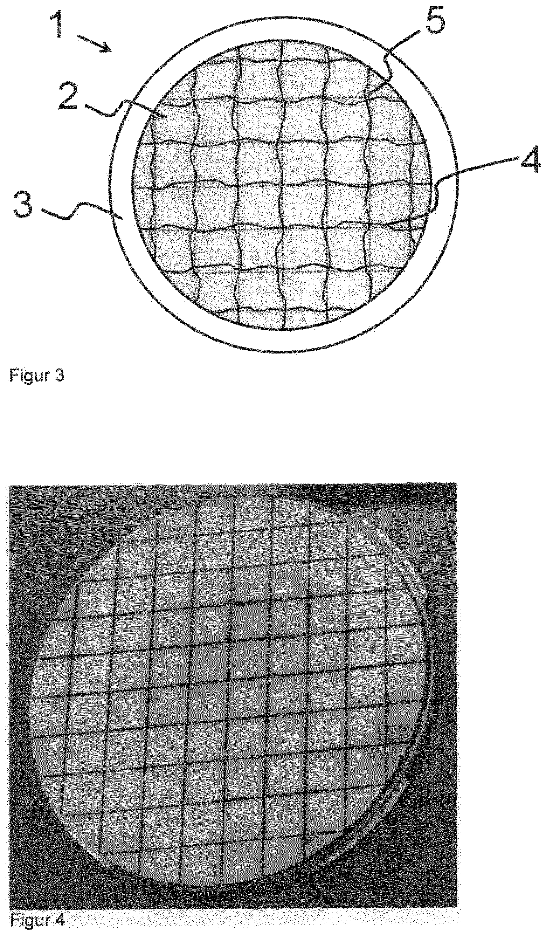

Figur 3 zeigt eine erfindungsgemäße Beschichtungsquelle nach der Einbringung der Risse (4). Die Risse (4) verlaufen weitestgehend entlang der Strukturierung (5).

Figur 4 zeigt eine Beschichtungsquelle die nach Beispiel 5 hergestellt wurde. Sie weist ein MoSiB Beschichtungsmaterial auf das mittels Hartlöten auf eine Rückplatte aus Mo aufgebracht und anschließend gereinigt wurde. Zusätzlich zu Rissen entlang der Strukturierung sind auch Risse vorhanden, die ein unregelmäßiges Netzwerk bilden. Es erfolgte kein Abplatzen kleinerer Stücke des Beschichtungsmaterials.

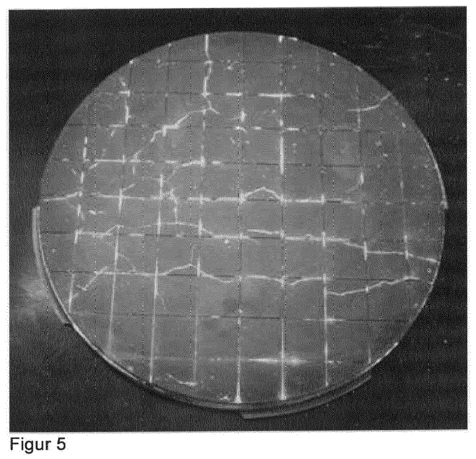

Figur 5 zeigt eine Beschichtungsquelle die nach Beispiel 6 hergestellt wurde. Sie weist ein TiB₂ Beschichtungsmaterial auf das mittels Hartlöten auf Mo Rückplatte aufgebracht wurde. Die eingebrachten Risse wurden mittels fluoreszierender Farbe über eine Farbeindringprüfung sichtbar gemacht.

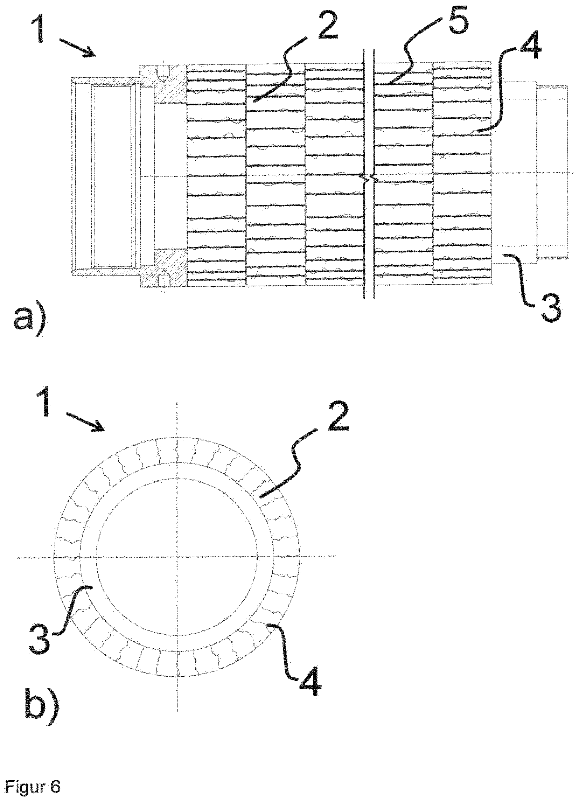

Figur 6 zeigt eine rohrförmige Beschichtungsquelle (1). In a) ist eine Seitenansicht auf die rohrförmige Beschichtungsquelle (1), in b) ist eine Draufsicht in Richtung der Rotationsachse der Beschichtungsquelle (1) gezeigt. Das Beschichtungsmaterial (2) ist in diesem Fall aus einzelnen zylindrischen Ringen aufgebaut, das Stützelement (3) ist als Stütz- bzw. Trägerrohr ausgebildet. Die Strukturierung (5) ist auf der Mantelfläche des Beschichtungsmaterials (2) angebracht, die Risse (4) verlaufen weitgehend entlang der Strukturierung (5).

Liste der verwendeten Bezugszeichen:
- 1: Beschichtungsquelle
- 2: Beschichtungsmaterial
- 3: Stützelement
- 4: Risse
- 5: Strukturierung
- d₁: Gesamtdicke der Beschichtungsquelle
- d₂: Dicke des Beschichtungsmaterials
- d₃: Dicke des Stützelements

## Patentansprüche

1. Beschichtungsquelle (1) zur physikalischen Gasphasenabscheidung, mit:
- Einem Beschichtungsmaterial (2) das aus einem Werkstoff mit einer Bruchdehnung von kleiner oder gleich 1% besteht und Risse (4) aufweist,
- Einem Stützelement (3) das an einer Oberfläche des Beschichtungsmaterials (2) mit diesem verbunden ist,
**dadurch gekennzeichnet, dass** das Beschichtungsmaterial (2) eine Strukturierung (5) an zumindest Teilen einer Oberfläche des Beschichtungsmaterials (2) aufweist, wobei die Strukturierung (5) aus Vertiefungen, Rillen, Kerben oder Schlitzen besteht, mit der Maßgabe, dass die Tiefe der Strukturierung so groß ist, dass in Tiefenrichtung mindestens 1 mm an Beschichtungsmaterial (2) übrig bleibt.

2. Beschichtungsquelle (1), nach Anspruch 1, wobei die Risse (4) weitgehend entlang der Strukturierung (5) verlaufen.

3. Beschichtungsquelle (1) nach einem der vorangehenden Ansprüche, wobei die Risse (4) mit einem Anteil an der gesamten Risslänge von mehr als 50% entlang der Strukturierung (5) verlaufen.

4. Beschichtungsquelle (1) nach einem der vorangehenden Ansprüche, wobei die Strukturierung (5) an der dem Stützelement (3) abgewandten Oberfläche des Beschichtungsmaterials (2) vorliegt.

5. Beschichtungsquelle (1) nach einem der vorangehenden Ansprüche, wobei die Strukturierung (5) aus einer Anordnung einer ersten Gruppe paralleler linienförmiger Vertiefungen und einer zweiten Gruppe paralleler linienförmiger Vertiefungen die in einem Winkel von 70° bis 110° zur ersten Gruppe paralleler linienförmiger Vertiefungen angeordnet sind besteht.

6. Beschichtungsquelle (1) nach einem der vorangehenden Ansprüche, wobei der thermische Ausdehnungskoeffizient des Beschichtungsmaterials (2) α₂ größer als der thermische Ausdehnungskoeffizient des Stützelements (3) α₃ ist.

7. Beschichtungsquelle (1) nach einem der vorangehenden Ansprüche, wobei das Beschichtungsmaterial (2) aus TiB₂, SiC, B₄C, MoSiB, oder CrSiB besteht.

8. Beschichtungsquelle (1) nach einem der vorangehenden Ansprüche, wobei, das Stützelement (3) aus Molybdän, Wolfram, Tantal, einer Molybdänbasislegierung, einer Wolframbasislegierung oder einer Tantalbasislegierung besteht.

9. Beschichtungsquelle (1) nach einem der vorangehenden Ansprüche, wobei der E-Modul des Stützelements (3) E₃ größer oder gleich 300 GPa ist.

10. Beschichtungsquelle (1) nach einem der vorangehenden Ansprüche, wobei das Verhältnis X = d₂/(d₂+d₃) der Dicke des Beschichtungsmaterials (2) d₂ zur Summe d₂+d₃ der Dicke des Beschichtungsmaterials (2) d₂ und Dicke des Stützelements (3) d₃ größer 0,5, bevorzugt größer oder gleich 0,6 ist.

11. Beschichtungsquelle (1) nach einem der vorangehenden Ansprüche, wobei diese plattenförmig ist.

12. Beschichtungsquelle (1) nach einem der Ansprüche1 bis 10, wobei diese rohrförmig ist.

13. Verfahren zur Herstellung einer Beschichtungsquelle (1) zur physikalischen Gasphasenabscheidung enthaltend die folgenden Schritte:
- Bereitstellen eines Beschichtungsmaterials (2) das aus einem Werkstoff mit einer Bruchdehnung von kleiner oder gleich 1% besteht;
- Strukturieren des Beschichtungsmaterials (2) zur Erzeugung einer Strukturierung (5) an zumindest Teilen einer Oberfläche des Beschichtungsmaterials (2), wobei die Strukturierung (5) aus Vertiefungen, Rillen, Kerben oder Schlitzen besteht, mit der Maßgabe, dass die Tiefe der Strukturierung so groß ist, dass in Tiefenrichtung mindestens 1 mm an Beschichtungsmaterial (2) übrig bleibt.;
- Bereitstellen eines Stützelements (3);
- Verbinden des Beschichtungsmaterials (2) mit dem Stützelement (3);
- Einbringung von Rissen (4) in das Beschichtungsmaterial (2)

14. Verfahren nach Anspruch 13, wobei das Strukturieren des Beschichtungsmaterials (2) durch Erodieren, Drahtschneiden, Schleifen oder Trennschneiden verwirklicht wird.

15. Verfahren nach Anspruch 13, wobei das Strukturieren des Beschichtungsmaterials (2) durch Einpressen eines profilierten Presswerkzeugs verwirklicht wird.

16. Verfahren nach einem der Ansprüche 13 bis 15, wobei die Strukturierung auf der Oberfläche des Beschichtungsmaterials (2) eingebracht wird, die sich nach dem Verbinden mit dem Stützelement (3) auf der dem Stützelement (3) abgewandten Oberfläche des Beschichtungsmaterials (2) befindet.

17. Verfahren nach einem der Ansprüche 13 bis 16, wobei das Verbinden des Beschichtungsmaterials (2) mit dem Stützelement (3) durch Hartlöten bei Temperaturen zwischen 400°C bis 950 °C realisiert wird.

18. Verfahren nach einem der Ansprüche 13 bis 17, wobei die Einbringung der Risse (4) durch ein Abkühlen von einer erhöhten Temperatur stattfindet.

19. Verfahren nach Anspruch 17, wobei die Einbringung der Risse (4) durch ein Abkühlen von der Temperatur des Hartlötens stattfindet.

20. Verfahren nach einem der Ansprüche 13 bis 19, wobei dieses zusätzlich folgenden Schritt enthält:
- Strahlen der Beschichtungsquelle

## Claims

1. Coating source (1) for physical vapour deposition, comprising:
- a coating material (2) which consists of a material having an elongation at break of less than or equal to 1% and has cracks (4),
- a support element (3) which is joined to the coating material (2) at a surface of the coating material (2),
**characterized in that** the coating material (2) has structuring (5) on at least parts of a surface of the coating material (2), wherein the structuring (5) consists of depressions, grooves, notches or slits, with the proviso, that the depth of the structuring is that great that at least 1 mm of coating material (2) remains in depth direction.

2. Coating source (1) according to Claim 1, wherein the cracks (4) run largely along the structuring (5).

3. Coating source (1), according to any of the preceding claims, wherein a proportion of more than 50% of the total crack length of the cracks (4) runs along the structuring (5).

4. Coating source (1) according to any of the preceding claims, wherein the structuring (5) is present on the surface of the coating material (2) facing away from the support element (3).

5. Coating source (1) according to any of the preceding claims, wherein the structuring (5) consists of an arrangement of a first group of parallel linear depressions and a second group of parallel linear depressions which are arranged at an angle of from 70° to 110° to the first group of parallel linear depressions.

6. Coating source (1) according to any of the preceding claims, wherein the coefficient of thermal expansion of the coating material (2) α₂ is greater than the coefficient of thermal expansion of the support element (3) α₃.

7. Coating source (1) according to any of the preceding claims, wherein the coating material (2) consists of TiB₂, SiC, B₄C, MoSiB or CrSiB.

8. Coating source (1) according to any of the preceding claims, wherein the support element (3) consists of molybdenum, tungsten, tantalum, a molybdenum-based alloy, a tungsten-based alloy or a tantalum-based alloy.

9. Coating source (1) according to any of the preceding claims, wherein the E modulus of the support element (3) E₃ is greater than or equal to 300 GPa.

10. Coating source (1) according to any of the preceding claims, wherein the ratio X = d₂/(d₂+d₃) of the thickness of the coating material (2) d₂ to the sum d₂+d₃ of the thickness of the coating material (2) d₂ and thickness of the support element (3) d₃ is greater than 0.5, preferably greater than or equal to 0.6.

11. Coating source (1) according to any of the preceding claims, wherein the coating source (1) is plate-shaped.

12. Coating source (1) according to any of Claims 1 to 10, wherein the coating source (1) is tubular.

13. Process for producing a coating source (1) for physical vapour deposition, which comprises the following steps:
- provision of a coating material (2) which consists of a material having an elongation at break of less than or equal to 1%;
- structuring of the coating material (2) to produce a structuring (5) on at least parts of a surface of the coating material (2) wherein the structuring (5) consists of depressions, grooves, notches or slits, with the proviso, that the depth of the structuring is that great that at least 1 mm of coating material (2) remains in depth direction;
- provision of a support element (3);
- joining of the coating material (2) to the support element (3);
- introduction of cracks (4) into the coating material (2).

14. Process according to Claim 13, wherein the structuring of the coating material (2) is effected by erosion, wire cutting, grinding or parting.

15. Process according to Claim 13, wherein the structuring of the coating material (2) is effected by pressing-in of a profiled pressing tool.

16. Process according to any of Claims 13 to 15, wherein the structuring is introduced on the surface of the coating material (2) which, after joining to the support element (3), is present on the surface of the coating material (2) facing away from the support element (3).

17. Process according to any of Claims 13 to 16, wherein the joining of the coating material (2) to the support element (3) is effected by brazing at temperatures in the range from 400°C to 950°C.

18. Process according to any of Claims 13 to 17, wherein the introduction of the cracks (4) takes place as a result of cooling from an elevated temperature.

19. Process according to Claim 17, wherein the introduction of the cracks (4) takes place as a result of cooling from the temperature of brazing.

20. Process according to any of Claims 13 to 19, wherein it additionally comprises the following step:
- particle blasting of the coating source.

## Revendications

1. Source de revêtement (1) pour le dépôt physique en phase vapeur, comprenant :
- un matériau de revêtement (2) qui est constitué par une matière présentant un allongement à la rupture inférieur ou égal à 1 % et qui présente des fissures (4),
- un élément support (3) qui est relié avec le matériau de revêtement (2) sur une surface de celui-ci,
**caractérisée en ce que** le matériau de revêtement (2) présente une structuration (5) sur au moins des parties d'une surface du matériau de revêtement (2), la structuration (5) étant constituée par des creux, des rainures, des encoches ou des fentes, à condition que la profondeur de la structuration soit telle qu'il reste au moins 1 mm de matériau de revêtement (2) dans la direction de la profondeur.

2. Source de revêtement (1) selon la revendication 1, dans laquelle les fissures (4) passent essentiellement le long de la structuration (5).

3. Source de revêtement (1) selon l'une quelconque des revendications précédentes, dans laquelle les fissures (4) passent le long de la structuration (5) sur une proportion de la longueur totale des fissures de plus de 50 %.

4. Source de revêtement (1) selon l'une quelconque des revendications précédentes, dans laquelle la structuration (5) est présente sur la surface opposée à l'élément support (3) du matériau de revêtement (2).

5. Source de revêtement (1) selon l'une quelconque des revendications précédentes, dans laquelle la structuration (5) est constituée par un agencement d'un premier groupe de creux linéaires parallèles et d'un deuxième groupe de creux linéaires parallèles qui sont agencés à un angle de 70° à 110° par rapport au premier groupe de creux linéaires parallèles.

6. Source de revêtement (1) selon l'une quelconque des revendications précédentes, dans laquelle le coefficient d'expansion thermique du matériau de revêtement (2) α₂ est supérieur au coefficient d'expansion thermique de l'élément support (3) α₃.

7. Source de revêtement (1) selon l'une quelconque des revendications précédentes, dans laquelle le matériau de revêtement (2) est constitué par TiB₂, SiC, B₄C, MoSiB ou CrSiB.

8. Source de revêtement (1) selon l'une quelconque des revendications précédentes, dans laquelle l'élément support (3) est constitué par du molybdène, du tungstène, du tantale, un alliage à base de molybdène, un alliage à base de tungstène ou un alliage à base de tantale.

9. Source de revêtement (1) selon l'une quelconque des revendications précédentes, dans laquelle le module E de l'élément support (3) E₃ est supérieur ou égal à 300 GPa.

10. Source de revêtement (1) selon l'une quelconque des revendications précédentes, dans laquelle le rapport X = d₂/(d₂+d₃) entre l'épaisseur du matériau de revêtement (2) d₂ et la somme d₂+d₃ de l'épaisseur du matériau de revêtement (2) d₂ et de l'épaisseur de l'élément support (3) d₃ est supérieur à 0,5, de préférence supérieur ou égal à 0,6.

11. Source de revêtement (1) selon l'une quelconque des revendications précédentes, dans laquelle celle-ci est plaquettaire.

12. Source de revêtement (1) selon l'une quelconque des revendications 1 à 10, dans laquelle celle-ci est tubulaire.

13. Procédé de fabrication d'une source de revêtement (1) pour le dépôt physique en phase vapeur, contenant les étapes suivantes :
- la mise à disposition d'un matériau de revêtement (2) qui est constitué par une matière présentant un allongement à la rupture inférieur ou égal à 1 % ;
- la structuration du matériau de revêtement (2) pour la formation d'une structuration (5) sur au moins des parties d'une surface du matériau de revêtement (2), la structuration (5) étant constituée par des creux, des rainures, des encoches ou des fentes, à condition que la profondeur de la structuration soit telle qu'il reste au moins 1 mm de matériau de revêtement (2) dans la direction de la profondeur ;
- la mise à disposition d'un élément support (3) ;
- la liaison du matériau de revêtement (2) avec l'élément support (3) ;
- l'introduction de fissures (4) dans le matériau de revêtement (2).

14. Procédé selon la revendication 13, dans lequel la structuration du matériau de revêtement (2) est réalisée par érosion, découpe au fil, ponçage ou découpe de séparation.

15. Procédé selon la revendication 13, dans lequel la structuration du matériau de revêtement (2) est réalisée par enfoncement d'un outil de compression profilé.

16. Procédé selon l'une quelconque des revendications 13 à 15, dans lequel la structuration est introduite sur la surface du matériau de revêtement (2) qui se trouve après la liaison avec l'élément support (3) sur la surface opposée à l'élément support (3) du matériau de revêtement (2).

17. Procédé selon l'une quelconque des revendications 13 à 16, dans lequel la liaison du matériau de revêtement (2) avec l'élément support (3) est réalisée par brasage fort à des températures comprises entre 400 °C et 950 °C.

18. Procédé selon l'une quelconque des revendications 13 à 17, dans lequel l'introduction des fissures (4) a lieu par un refroidissement à partir d'une température élevée.

19. Procédé selon la revendication 17, dans lequel l'introduction des fissures (4) a lieu par un refroidissement à partir de la température du brasage fort.

20. Procédé selon l'une quelconque des revendications 13 à 19, dans lequel celui-ci contient en outre l'étape suivante :
- le traitement par des jets de la source de revêtement.
